# EUROPEAN PATENT APPLICATION

(11) **EP 3 413 360 A1**
(43) Date of publication of application: **12.12.2018**
(21) Application number: 17382346.9
(22) Date of filing: 07.06.2017
(51) Int. Cl.: H01L 33/48, H01L 33/58, H01L 33/64

(54) **ELECTRONIC ASSEMBLY AND LIGHTING DEVICE**

(71) Applicant: Valeo Iluminacion, 23600 Martos (ES)
(72) Inventor: TEBA, Daniel, 23600 Martos (ES)

(57) **Abstract**

The invention provides an electronic assembly (1) comprising a support (2), a first wall (22), a second wall (23) and an electronic part (3). The support (2) comprises a protected surface (21), the protected surface (21) being laterally delimited by a first edge (211) and by a second edge (212). The first wall (22) extends longitudinally along the first edge (211), protruding from the protected surface (21). The second wall (23) extends longitudinally along the second edge (212), protruding from the protected surface (21). The electronic part (3) is arranged on the support (2), in such a way that the electronic part (3) comprises a protected portion (31) located within the protected surface (21).

## Description

### TECHNICAL FIELD

This invention is related to the field of the manufacturing of automotive lighting devices, and more specifically to the protection of elements comprised in said devices.

### STATE OF THE ART

Current lighting devices comprise some fragile elements, such as semiconductor light sources, or any other elements which may be damaged if accidentally touched.

This fact usually causes problems during manufacturing or packaging of the electronic assembly. A solution to such problems known in the state of the art consists of providing a plastics film or a resin layer over the surface of the electronic element. This solution may be time-consuming, since it requires at least an additional manufacturing step to apply the protective layer.

The present invention aims at providing an electronic assembly wherein these electronic elements are permanently protected from manipulation, without falling back on an additional manufacturing step or on a further temporary protective element whose good condition need to be monitored.

### DESCRIPTION OF THE INVENTION

The invention provides a solution for this problem by means of an electronic assembly according to claim 1 and a lighting device according to claim 14. Preferred embodiments of the invention are defined in dependent claims.

In an inventive aspect, the invention provides an electronic assembly comprising:
a support comprising a protected surface, the protected surface being laterally delimited by a first edge and by a second edge;
a first wall extending longitudinally along the first edge, protruding from the protected surface;
a second wall extending longitudinally along the second edge, protruding from the protected surface;
an electronic part arranged on the support, in such a way that the electronic part comprises a protected portion located within the protected surface.

The provision of the first and second walls is a simple and economic manner of protecting the electronic element; as will be detailed below, these walls may for instance be obtained in the same moulding step as the rest of the support. The first and second walls may also be incorporated into the support in a further step, in which case they may be made of plastics or of any other suitable material.

In some particular embodiments, the electronic part comprises a semiconductor light source.

A semiconductor light source takes a particular advantage out of this electronic assembly, since the vast majority of them are very sensitive and this assembly would make a protective layer unnecessary.

In some particular embodiments, the semiconductor light source comprises a light emitting diode (LED).

This type of light sources is one of the most efficient and sensitive, and is very suitable for this arrangement.

In some particular embodiments, the electronic part comprises a ribbon connection or a wire bonding connection between the semiconductor light source and a conductive track.

In these embodiments, the connection may also benefit from the protection provided by the first and second walls, since the connection is very close to the electronic part, and it is very easy to enlarge said protection, so that it covers both the electronic part and the connection.

In a particular embodiment, the protected portion corresponds to the whole electronic part.

The protected portion may be limited to the zones where electronic elements more prone to deterioration are supposed to be installed. This configuration is particularly suitable for very sensitive electronic assemblies, which require maximum protection.

In a particular embodiment, the support is three-dimensional.

A "three-dimensional" support should be construed as a support whose surface on which the conductive track extends is not contained in a single plane.

In a particular embodiment, the first edge and/or the second edge is curved.

These embodiments may be useful when dealing with electronic elements with a curved border which need to be protected tightly, with walls that adapt to its silhouette.

In a particular embodiment, the first edge and/or the second edge is straight.

These embodiments may be useful when dealing with electronic elements with a straight border which need to be protected tightly, with walls that adapt to its silhouette, or when the shape is not relevant, and a quick and cheap solution is required.

In a particular embodiment, the first wall comprises a first planar top surface and the second wall comprises a second planar top surface.

Such first and second planar top surfaces are the uppermost parts of the first and second walls, i.e. the parts the farthest from the support (or from the rest of the support, in the event the walls are part of the support). When the region of the electronic assembly comprising the first and second wall is manipulated, the first and second planar top surfaces keep the protected portion from being directly contacted.

In a particular embodiment, the first wall has a first height, being the distance between the protected surface and the first planar top surface and the second wall has a second height, being the distance between the protected surface and the second planar top surface, the first and second heights being between 1 and 10 mm, and preferably between 6 and 8 mm, depending on the height and technical features of the electronic part to be protected. The person skilled in the art would know which height to choose depending on the limitations inherent to the electronic part. For example, in the particular embodiment where the electronic part is a LED, these first and second heights are such that the walls do not create any interference with the Lambertian light distribution of said LED. The person skilled in the art would know which height to choose depending on the limitations inherent to the electronic part.

The height of the first and second walls are between a minimum value, so that they protect, and a maximum value, so that they do not interfere with the functions performed by the electronic part. For example, in the event that the electronic part is a light source, the first and second walls must not be in the path of the light beam emitted by this light source.

In some particular embodiments, the minimum distance between the first edge and the second edge is between 1 and 40 mm, and preferably between 10 and 25 mm, also depending on the geometry and technical features of the electronic part to be protected.

This distance is enough for an electronic part to be arranged between such first and second walls.

In some particular embodiments, the support is a plastics substrate.

This embodiment is suitable for those electronic parts which are being arranged directly on a plastics substrate, such as some types of light sources.

In some particular embodiments, the support is a heatsink.

This embodiment is suitable for those electronic parts which are being arranged directly on a plastics substrate, such as different types of light sources.

In a second inventive aspect, the invention provides a lighting device for an automotive vehicle, the device comprising:
an electronic assembly according to the preceding inventive aspect, the electronic part being a light source adapted for emitting light, preferably a semiconductor light source;
an optical element suitable for receiving light emitted by the electronic part and for shaping the light into a light pattern projected outside the lighting device,
a housing accommodating the electronic assembly and the optical element.

The optical element can be, among others, a reflector for reflecting the light emitted by the light source, a collimator for concentrating the light, a light guide, a projection lens suitable for outwardly projecting the desired light pattern when the lighting device is installed in the automotive vehicle or the combination of these and other optical elements well known by the person skilled in automotive lighting.

A device for providing a signalling function is also considered as a lighting device in the present document.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out.

The drawings comprise the following figures:
Figure 1 shows a perspective view of an electronic assembly according to the invention.
Figure 2 shows a cross section view of an electronic assembly according to the invention.
Figure 3 shows a lighting device comprising the electronic assembly according to the invention.

### DETAILED DESCRIPTION OF THE INVENTION

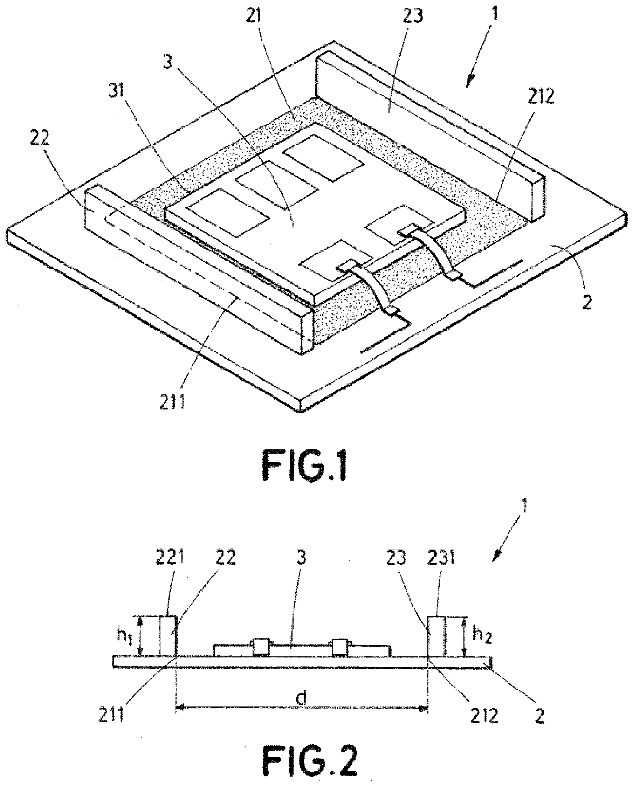

Figure 1 shows a perspective way of an electronic assembly according to the invention. In this figure, the electronic assembly 1 comprises
a support 2 comprising a protected surface 21, the protected surface 21 being laterally delimited by a first edge 211 and by a second edge 212;
a first wall 22 extending longitudinally along the first edge 211, protruding from the protected surface 21;
a second wall 23 extending longitudinally along the second edge 212, protruding from the protected surface 21;
an electronic part 3 arranged on the support 2, in such a way that the electronic part 3 comprises a protected portion 31 located within the protected surface 21.

As may be seen in this figure, the support 2 is three-dimensional, and the protected portion 31 corresponds to the whole electronic part 3, so that the whole electric part 3 is comprised within the protected portion 31.

In the embodiment seen in this figure, the electronic part 3 is a semiconductor light source, such as a light emitting diode (LED). These LEDs are very sensitive, so this arrangement makes it unnecessary the use of protective layers to prevent damage during the manufacturing process.

Further, this LED is attached to the conductive tracks by means of a ribbon connection or a wire bonding connection, which ensures that the LED may be placed in the most optimal location, in terms of heat dissipation and dimensional accuracy, while the conductive track is arranged following a conventional path, thus uncoupling the location of these two elements of the electronic assembly 1.

In the embodiment shown in this figure, the first edge 211 and the second edge 212 are straight. This embodiment is particularly suitable for electronic parts 3 which have straight edges. However, in different embodiments where the electronic part 3 has, e.g., round edges, the first edge 211 and the second edge 212 may adapt to this shape, therefore being curved.

In this figure, the support 2 is a heatsink, although in other embodiments of the invention, this support 2 may be a plastics substrate. However, as may be seen in this embodiment, the first wall 22 and the second wall 23 may extend beyond the support 2 where the electronic part 3 is arranged, since mechanical protection may be required in a greater area than just the zone then this electronic part 3 is installed.

Figure 2 shows a cross section view of the electronic assembly of Figure 1, in a plane which is perpendicular to the electronic part 3, which cuts said electronic part 3 and the first 22 and second 23 walls.

As may be seen in this figure, the first wall 22 has a first height h1 and comprises a first planar top surface 221. The first height h1 is defined as the distance between the protected surface 21 and the first planar top surface 221.

The second wall 23 in turn has a second height h2 and comprises a second planar top surface 231. The second height h2 is defined as the distance between the protected surface 21 and the second planar top surface 231.

The first h1 and second h2 heights are comprised between 6 and 8 mm, because the electronic part 3 is a LED which emits a Lambertian light beam which would interfere with the first 22 and second 23 wall in the event that the first h1 and second h2 heights were greater than this value.

The minimum distance d between the first edge 211 and the second edge 212 is between 20 and 25 mm.

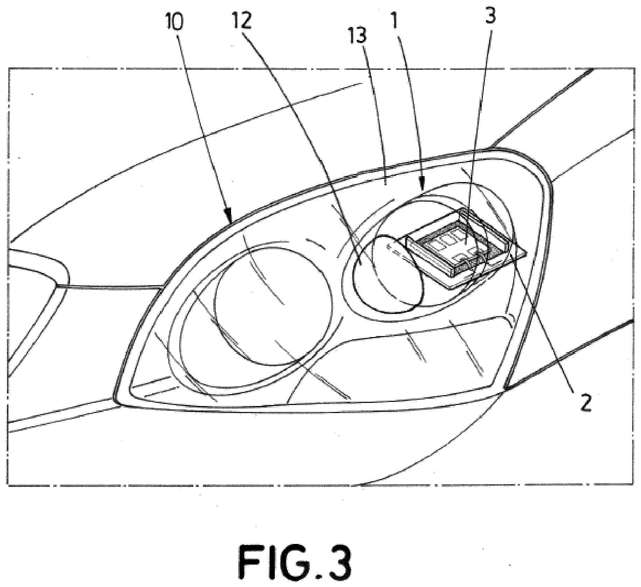

Figure 3 shows a lighting device 10 comprising the electronic assembly of Figures 1 and 2. This lighting device comprises:
an electronic assembly 1 as shown in the previous figures, the electronic part 3 being a light source adapted for emitting light, preferably a semiconductor light source, such as a LED;
an optical element 12 suitable for receiving light emitted by the electronic part 3 and for shaping the light into a light pattern projected outside the lighting device,
a housing 13 accommodating the electronic assembly 1 and the optical element 12.

## Claims

1. An electronic assembly (1) comprising:
a support (2) comprising a protected surface (21), the protected surface (21) being laterally delimited by a first edge (211) and by a second edge (212);
a first wall (22) extending longitudinally along the first edge (211), protruding from the protected surface (21);
a second wall (23) extending longitudinally along the second edge (212), protruding from the protected surface (21);
an electronic part (3) arranged on the support (2), in such a way that the electronic part (3) comprises a protected portion (31) located within the protected surface (21).

2. Electronic assembly (1) according to claim 1, wherein the electronic part (3) comprises a semiconductor light source.

3. Electronic assembly (1) according to claim 2, wherein the semiconductor light source comprises a light emitting diode (LED).

4. Electronic assembly (1) according to any of claims 2 or 3, wherein the electronic part (3) comprises a ribbon connection or a wire bonding connection between the semiconductor light source and a conductive track.

5. Electronic assembly (1) according to any one of the preceding claims, wherein the protected portion (31) corresponds to the whole electronic part (3).

6. Electronic assembly (1) according to any one of the preceding claims, wherein the support (2) is three-dimensional.

7. Electronic assembly (1) according to any of the preceding claims wherein the first edge (211) and/or the second edge (212) is curved.

8. Electronic assembly (1) according to any of the preceding claims wherein the first edge (211) and/or the second edge (212) is straight.

9. Electronic assembly (1) according to any one of the preceding claims, wherein the first wall (22) comprises a first planar top surface (221) and the second wall (23) comprises a second planar top surface (231).

10. Electronic assembly (1) according to claim 9, wherein the first wall (21) has a first height (h1), being the distance between the protected surface (21) and the first planar top surface (221) and the second wall (22) has a second height (h2), being the distance between the protected surface (21) and the second planar top surface (231), the first (h1) and second (h2) heights being between 1 and 10 mm, and preferably between 6 and 8 mm.

11. Electronic assembly (1) according to any one of the preceding claims, wherein the minimum distance (d) between the first edge (211) and the second edge (212) is between 1 and 40 mm, preferably between 10 and 25 mm.

12. Electronic assembly (1) according to any one of the preceding claims, wherein the support (2) is a plastics substrate.

13. Electronic assembly (1) according to any of claims 1 to 11, wherein the support (2) is a heatsink.

14. A lighting device (10) for an automotive vehicle, the device comprising:
an electronic assembly (1) according to any one of claims from 1 to 10, the electronic part (3) being a light source adapted for emitting light, preferably a semiconductor light source;
an optical element (12) suitable for receiving light emitted by the electronic part (3) and for shaping the light into a light pattern projected outside the lighting device,
a housing (13) accommodating the electronic assembly (1) and the optical element (12).
